# EUROPEAN PATENT APPLICATION

(11) **EP 4 625 608 A1**
(43) Date of publication of application: **01.10.2025**
(21) Application number: 24166253.5
(22) Date of filing: 26.03.2024
(51) Int. Cl.: H01M 10/48, G01R 31/3835, G01R 31/396, H01M 10/613, H01M 10/667, H01M 50/519, H05K 1/02

(54) **SYSTEMS AND METHODS FOR ELECTRICAL ENERGY STORAGE CELL TEMPERATURE MEASUREMENTS**

(71) Applicant: Instagrid GmbH, 71636 Ludwigsburg (DE)
(72) Inventor: Zürner, Raphael, Ludwigsburg (DE); Gutknecht, Philipp, Mönsheim (DE)
(74) Representative: Eisenführ Speiser

(57) **Abstract**

It is disclosed a circuit comprising: electrical energy storage cell(s) (EESCs); a circuit board comprising an electrically isolating substrate; an electrically conductive terminal (ECT) connected between EESCs and the circuit board (ECT being configured to concurrently facilitate (i) an electrical connection between EESC(s) and CB and (ii) a transfer of heat from the EEC(s) to the electrically isolating substrate of CB; and a temperature sensor mounted to a surface of CB and configured to measure a temperature of EESC(s) based on a temperature of the electrically isolating substrate of CB. The temperature sensor is electrically isolated from ECT. Heat is allowed to flow from EESC(s) to the temperature sensor via ECT and the electrically isolating substrate. Other aspects such as methods are also disclosed.

## Description

### BACKGROUND

### Description of the Related Art

Battery cell packs are often used to power electronic devices. The temperature of the battery cells thereof may be monitored during use of the same. Long pinned or wired temperature sensors are often used for the temperature measurements. These temperature sensors are typically mounted in a way that a battery cell temperature is coupled strongly therewith. In this regard, each temperature sensor is manually placed at a position near the battery cell(s). Thereafter, the pins or wires of the temperature sensor may be soldered to a respective pad on a circuit board. In effect, the manufacturing process of the battery cell device is relatively manually intensive, inefficient, time consuming and costly.

### SUMMARY

The present disclosure concerns a circuit comprising: one or more electrical energy storage cells; a circuit board comprising an electrically isolating substrate; an electrically conductive terminal connected between at least one of the electrical energy storage cells and the circuit board (the electrically conductive terminal being configured to concurrently facilitate (i) an electrical connection between the at least one of the electrical energy storage cells and the circuit board and (ii) a transfer of heat from the at least one of the electrical energy storage cells to the electrically isolating substrate); and a temperature sensor mounted to a surface of the circuit board and configured to measure a temperature of the at least one of the electrical energy storage cells based on a temperature of the electrically isolating substrate of the circuit board. The temperature sensor is electrically isolated from the electrically conductive terminal. Heat is allowed to flow from the at least one of the electrical energy storage cells to the temperature sensor via the electrically conductive terminal and the electrically isolating substrate.

The present disclosure also concerns implementing systems and methods for operating a circuit. The methods comprise: using a conductive terminal to concurrently facilitate (i) a measurement of a voltage of an electrical energy storage cell and (ii) a transfer of heat from the electrical energy storage cell to a conductive plane provided within a circuit board; allowing the heat to flow from the electrical energy storage cell to a substrate of the circuit board via the conductive terminal and the conductive plane; and using a temperature sensor, which is mounted to a surface of the circuit board, to measure a temperature of the electrical energy storage cell based on a temperature of the substrate of the circuit board. The temperature sensor is electrically isolated from the conductive terminal and the conductive plane.

### BRIEF DESCRIPTION OF THE DRAWINGS

The present solution will be described with reference to the following drawing figures, in which like numerals represent like items throughout the figures.
FIG. 1 provides a perspective view of a power supply.
FIG. 2 provides an illustrative block diagram of the power supply shown in FIG. 1.
FIG. 3 provides a perspective view of an energy module of the power supply shown in FIG. 1.
FIG. 4 provides an assembly view of the energy module shown in FIG. 3.
FIG. 5 provides an illustrative block diagram of a circuit in the energy module shown in FIGS. 3-4.
FIGS. 6-7 provide illustrations of an energy module that are useful for understanding a conventional placement of a temperature sensor therein.
FIGS. 8-10 provide illustrations that are useful for understanding an energy module circuit with a surface mount temperature sensor in accordance with the present solution.
FIG. 11 provides an illustration of another energy module circuit with a surface mount temperature sensor in accordance with the present solution.
FIG. 12 provides an illustration of an energy module circuit with an electrically isolating and thermally conductive member connected between a surface mount temperature sensor and a conductive terminal.
FIGS. 13A-13B (collectively referred to herein as "FIG. 13") provide illustrations of thermal isolation features.
FIG. 14 provides an illustration showing an energy module circuit having a plurality of voltage sensors and temperature sensors.
FIG. 15 provides a flow diagram of an illustrative method for operating a circuit.

### DETAILED DESCRIPTION

The present solution is described with reference to the attached figures. The figures are not drawn to scale and they are provided merely to illustrate the instant solution. Several aspects of the present solution are described below with reference to example applications for illustration. It should be understood that numerous specific details, relationships, and methods are set forth to provide a full understanding of the present solution. One having ordinary skill in the relevant art, however, will readily recognize that the present solution can be practiced without one or more of the specific details or with other methods. In other instances, well-known structures or operations are not shown in detail to avoid obscuring the present solution. The present solution is not limited by the illustrated ordering of acts or events, as some acts may occur in different orders and/or concurrently with other acts or events. Furthermore, not all illustrated acts or events are required to implement a methodology in accordance with the present solution.

It should also be appreciated that the terminology used herein is for the purpose of describing particular embodiments only and is not intended to be limiting of the present solution. As used herein, the singular forms "a", "an" and "the" are intended to include the plural forms as well, unless the context clearly indicates otherwise. Furthermore, to the extent that the terms "including", "includes", "having", "has", "with", or variants thereof are used in either the detailed description and/or the claims, such terms are intended to be inclusive in a manner similar to the term "comprising."

Further, unless otherwise defined, all terms (including technical and scientific terms) used herein have the same meaning as commonly understood by one of ordinary skill in the art to which this solution belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As noted above, conventional manufacturing processes of battery cell devices are relatively manually intensive, inefficient, time consuming and costly. Thus, there is a need for a battery cell design that facilitates an improved manufacturing process. The present solution is directed to a novel temperature sensor design that allows for an improved manufacturing process for battery devices with a cell temperature monitoring feature.

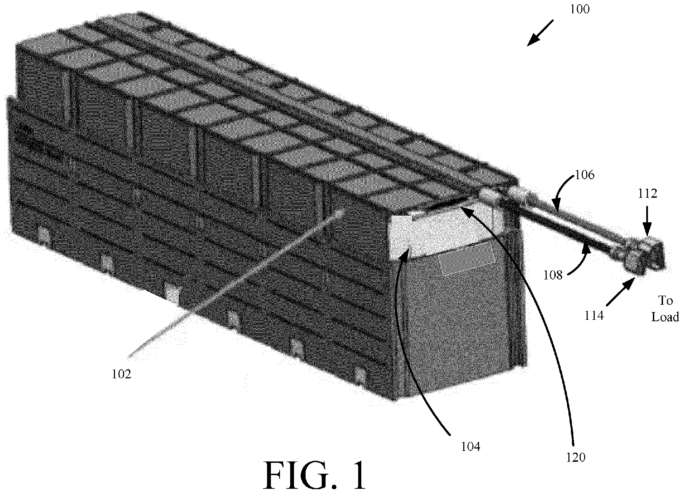

FIG. 1 provides an illustration of a power supply **100** which may be portable or otherwise mobile. The power supply **100** may have a size and weight to allow a single individual to carry the same with relative ease and/or to allow the same to be carried in a backpack or other bag. Power supply **100** may be connected in series or parallel with other power supplies to form a power supply unit.

Power supply **100** is generally configured to supply electric power to a load (not shown in FIG. 1). The load can include any electronic device that needs to be supplied power. Such loads can include, but are not limited to, another power supply, communication devices, media devices, golf carts, electric appliances, computing devices, and/or professional or home energy storage systems.

As shown in FIG. 1, the power supply **100** comprises a housing **102** in which a plurality of energy modules **104** are housed. Each energy module **104** is generally configured to convert direct current (DC) outputs from internal electrical energy storage cells into an alternating current (AC) output of the energy module. The electrical energy storage cells can include, but are not limited to, battery cells and/or super capacitors. The energy modules **104** are electrically connected to each other via insulated wires **106, 108.** In this way, the AC outputs of the energy modules are combined or otherwise summed together to produce the AC output power of the power supply **100.** More specifically, the energy modules **104** are connected in series in a controllable manner to supply different voltages at the output of the power supply **100.** Connectors **112, 114** are provided at the distal ends of insulated wires **106, 108** to provide a means to connect the output of the power supply **100** to the load.

In some uses, more than one instance of the power supply **100** may be coupled together to obtain a larger capacity power supply and/or a multi-voltage power supply. Such plurality of instances of the power supply **100** may, for example, be enclosed in a common housing (not shown in FIG. 1). It is further possible to obtain multi-phase power supplies using multiple instances of the power supply **100.** It shall be appreciated that such arrangements may further benefit from a reliable thermal monitoring of the electrical energy storage cells which are packed together.

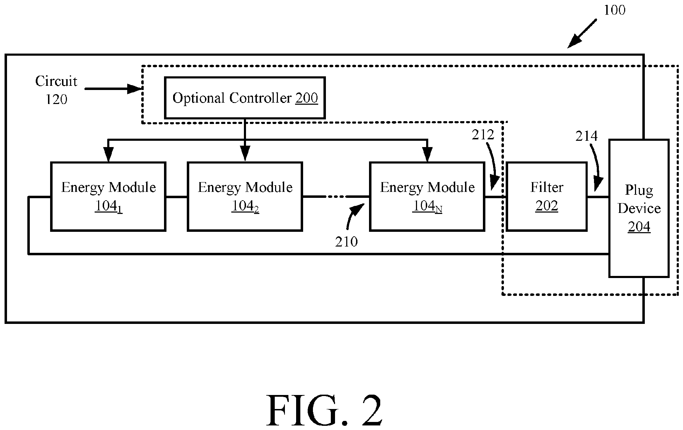

Operation of the energy modules **104** may be controlled using an internal circuit **120.** An illustrative technique for controlling the energy modules will now be discussed in relation to the block diagram of FIG. 2. The energy modules are referred to in FIG. 2 by reference numbers **104₁, 104₂,** ..., **104_{N}**. The energy modules **104₁, 104₂,** ..., **104_{N}** are collectively referred to herein as energy modules **104. N** is an integer equal to or greater than one.

As shown in FIG. 2, circuit **120** may comprise an optional controller **200,** a filter **202** and a plug device **204.** Controller **200** may reside external to the power supply **100** in some scenarios in which the power supply **100** comprises part of a grid. The grid can include a plurality of power supplies that are connected to each other and controlled by a unit controller. Controller **200** is shown internal to the power supply **100** for ease of illustration and explanation of the system operations. However, the present solution is not limited to the shown configuration. The plug device **204** may include the wires (e.g., wires **106, 108** of FIG. 1), connectors (e.g., connectors **112, 114** of FIG. 1), and/or other components to facilitate the supply of power to a load.

The controller **200** is configured to selectively activate and deactivate the energy modules **104** for causing the power supply **100** to deliver AC power to the load with the correct voltage, current and frequency. The controller **200** is connected to each of the energy modules **104₁, 104₂,** ..., **104_{N}** so that the energy modules can be controlled individually thereby. The controller **200** is configured to selectively transition each energy module between a battery mode and a bypass mode. When an energy module is in its battery mode, the internal electrical energy storage cells are switched into the circuit such that they are connected between terminals **210, 212** thereof. As such, a voltage output from the electrical energy storage cells is provided at terminal **210** and **212.** In contrast, when the energy module is in a bypass mode, the internal electrical energy storage cells are bypassed such the terminals **210, 212** are directly shortened to each other. In effect, no voltage from the electrical energy storage cells is provided at terminal **210** or **212** of the energy module.

Particularly, an energy module may provide the following operation modes: a Hi-Z (high impedance) mode in which module output is set to a high-impedance state (e.g., associated with none of the switches in the module being turned ON); a bypass mode in which the energy module is not contributing any battery voltage, but letting the current flow via it (e.g., via both low-side switches of the H-bridge being turned ON); a conducting + mode in which the electrical energy storage cells are connected to the module output in a given polarity; and a conducting - mode in which the electrical energy storage cells are connected to the module output in an opposite polarity as compared to the conducting + mode.

By successively transitioning the energy modules from the bypass mode to the battery mode, the combined output voltage of the energy modules **104** can be increased in steps. Similarly, by successively transitioning the energy modules from the battery mode to the bypass mode, the combined output voltage of the energy modules **104** can be decreased in steps. The combined output voltage can be changed by an amount equal to the output voltage ***V_{M}*** of one energy module. Thus, the combined output voltage ***V_{C}*** can vary between zero volts and **N** times ***V_{M}*** Volts (i.e., 0 Volts < ***V_{C}*** < N. ***V_{M}*** Volts). For obtaining finer transition between the ***V_{M}*** steps, at least one energy module can be operated in a pulse-width-modulation (PWM) mode with time varying duty-cycle. The combined output voltage ***V_{C}*** can be smoothed by filter **202** so as to produce a voltage signal on line **214.** The voltage signal on line **214** may have sinusoidal characteristics, DC signal characteristics or other waveform characteristics.

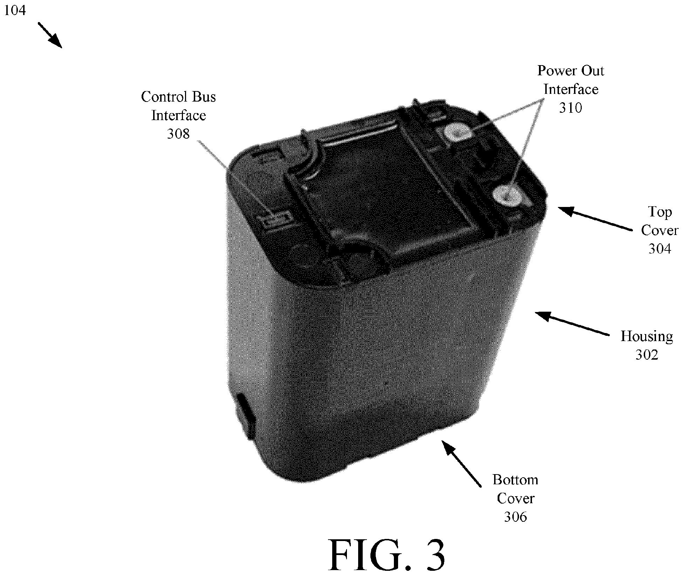

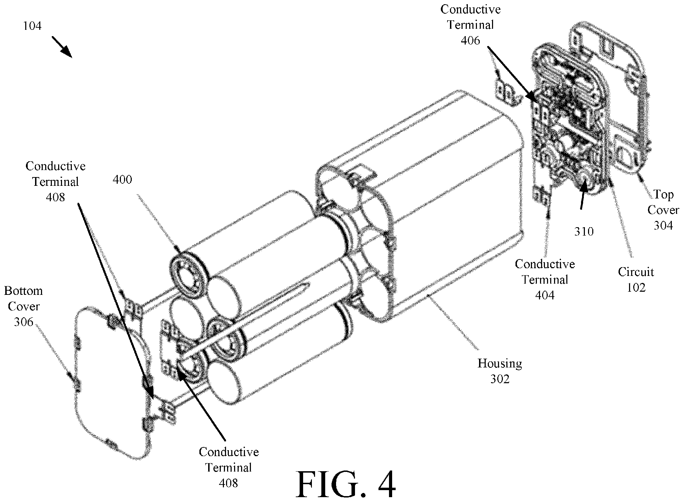

FIG. 3 provides an illustration of an energy module **104.** An assembly view of the energy module **104** is provided in FIG. 4. Energy modules **104** of FIG. 1 and 104**1, 104₂,** ..., **104_{N}** of FIG. 2 may be the same as or similar to the energy module shown in FIG. 3.

Energy module **104** comprises a housing **302** in which electrical energy storage cells **400** are housed so as to maintain certain positions relative to each other. The electrical energy storage cells **400** can be arranged in two rows of three cells as shown in FIGS. 3-4. The present solution is not limited in this regard. The electrical energy storage cells can have a different arrangement than that shown in FIGS. 3-4. Any number of electrical energy storage cells can be provided in the energy module in accordance with a given application. Each electrical energy storage cell may include, but is not limited to, a lithium-ion cell. Hence, the energy module **104** may comprise electrical energy storage cells which are in the form of an electrical battery, capacitor or supercapacitor, their likes or their combinations. The electrical energy storage cell, or lithium-ion cell, may have a cylindrical shape as shown or another shape (e.g., a rectangular shape) not shown.

A top cover **304** and a bottom cover **306** are provided for the housing **302.** The covers **304, 306** may be configured to provide an environment seal with the housing **302.** The environmental seal may be facilitated by gaskets (not visible or shown in FIGS. 3-4) compressed between the covers **304, 306** and the housing's sidewalls.

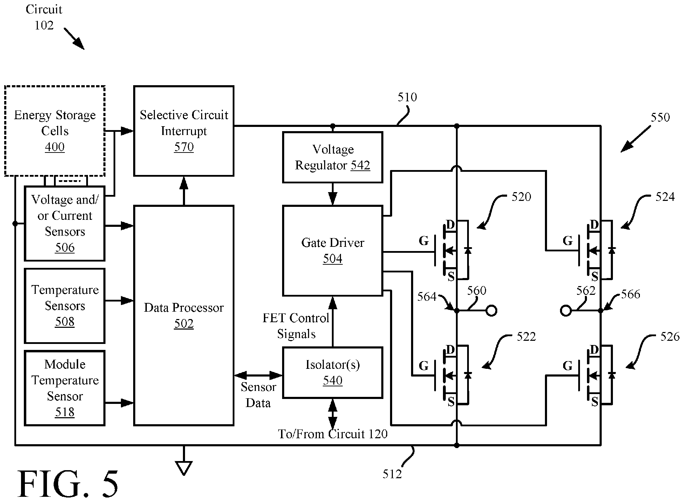

The safe and reliable operation of the energy module **104** requires the constant monitoring of each electrical energy storage cell **400** to detect when its current, voltage and/or temperature fall outside of defined operating range(s). This monitoring is achieved using a circuit **120** that is also housed in the housing **302.** Conductive terminals **404, 406, 408** are provided to connect the electrical energy storage cells **400** to the circuit **120** for at least voltage measurements. A block diagram of circuit **120** is provided in FIG. 5.

As shown in FIG. 5, circuit **120** comprises voltage and current sensors **506** connected to the electrical energy storage cells **400.** These sensors **506** are configured to measure the voltage and/or current of each electrical energy storage cell. Circuit **120** also comprises temperature sensors **508** and a module temperature sensor **518.** Each temperature sensor **508** is configured to measure a temperature of one or more electrical energy storage cells, while the module temperature sensor **518** is configured to measure an internal temperature of the energy module. More specifically, the temperature sensor senses the temperature close to the power stage consisting of FETs **520, 522, 522, 526.** These sensor measurements are communicated from the sensors **506, 508, 518** to the data processor **502** for processing and measurement acquisition. The data processor **502** can perform operations to communicate sensor measurements as sensor data to circuit **120,** and/or perform operations to analyze the sensor measurements to determine if certain criteria is met. For example, if a parameter measurement falls outside of defined range at a given time or for a certain amount of time, then the data processor **502** causes the circuit interrupt **570** to transition from a closed state to an open state such that the power input and output of the energy module **104** is turned off. The parameter measurement can include a voltage measurement, a current measurement or a temperature measurement.

The circuit **120** also comprises a gate driver **504** and a transistor active bridge **550.** The transistor active bridge circuit **550** is supplied a DC voltage waveform from the electrical energy storage cells **400.** As such, the transistor active bridge circuit **550** is connected to electrical energy storage cells **400** via input lines **510, 512.** The transistor active bridge circuit **550** is also connected between a pair of output lines **560, 562.** The output lines **560, 562** are connected to the power interface **210/212** of FIG. 2 and/or **310** of FIG. 3.

The transistor active bridge circuit **550** includes a plurality of switches, shown in this example as field-effect transistors (FETs) **520, 522, 524, 526** of an N-channel type. Each of the FETs may comprise a metal-oxide semiconductor FET (MOSFET). Alternatively, other kinds of switches are also possible, such as but not limited to bipolar junction transistor (BJT) or insulated gate bipolar transistor (IGBT) based switches, or even relays. Each FET **520, 522, 524, 526,** in this example, has three (3) terminals respectively defined as a source **S,** a gate **G** and a drain **D.** An electrical path is be provided from the source to the drain of each FET **520, 522, 524, 526.** This path is generally referred to herein as the source-drain path. A source-drain path of first FET **520** is connected in series with a source-drain path of the second FET **522.** The series connected transistor pair **520, 522** form a first series transistor combination that is connected across the input lines **510, 512.** A source-drain path of the third FET **524** is connected in series with a source-drain path of the fourth FET **526** to form a second series transistor combination connected across the input lines **510, 512.**

The transistor active bridge **550** can have an output defined by output lines **560, 562.** A first one of the output lines **560** can be connected to the first series combination **520, 522** at an interconnection point **564** between the first and the second field-effect transistors **520, 522.** A second one of the output lines **562** can be connected to the second series combination **524, 526** at an interconnection point **266** between the third and fourth field-effect transistors **524, 526.**

Gate driver **504** is provided for driving the gate **G** of each FET **520, 522, 524, 526.** In this regard, the gate driver is configured to supply a voltage to the gate **G** of each FET at certain times for switching the FET to its "on" state or "off' state. The gate driver is also configured to stop supplying the voltage to the gate **G** of the FET at certain times for switching the FET to its "on" state or "off' state. Gate driver circuits are well known. Known or to be known gate driver circuit can be used here. In some cases, the gate driver **504** may be realized as different circuits for each or some of the FETs **520, 522, 524, 526.**

When the gate driver **504** communicates gate control signals to the FETs **520, 526,** the FETs **520, 526** will be biased and switch to their "on" states, thus providing voltage from the energy storage cells **400** at the output lines **560, 562.** In effect, current may flow between the drain **D** and source **S** of these FETs to supply a load connected between the output lines **560, 562.** The FETs **520, 526** transition back to their "off' states when the gate control signals are no longer being output from the gate driver circuit. Similarly, when the gate driver **504** communicates gate control signals to the FETs **522, 524,** the FETs **522, 524** will be biased and switched to their "on" states, thus providing voltage from the energy storage cells **400** at the output lines **560, 562** but in the opposite polarity as compared to the "on" state of the FETs **520** and **526.** In effect, current may flow between the drain **D** and source S of these FETs **522, 524** to supply a load connected between the output lines **560, 562.** It shall be appreciated that the load will experience current in opposite polarity in case FETs **522, 524** are "on", as compared to the case when FETs **520, 526** are "on". The FETs **522, 524** transition back to their "off' states when the gate control signals are no longer being output from the gate driver. The gate driver may be configured to prevent the two FETs in each series pair **520/526** and **522/524** from being closed simultaneously or concurrently.

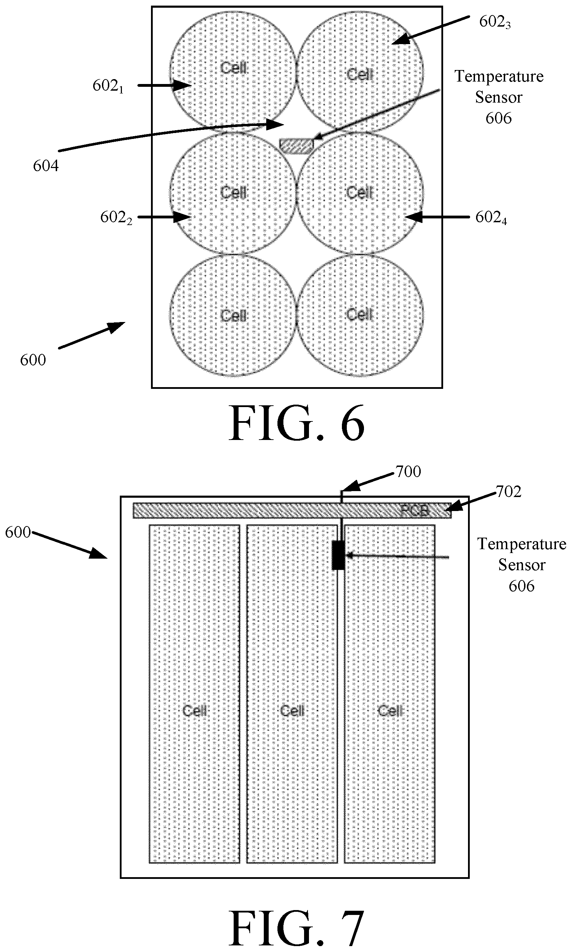

The manufacturing process of conventional energy modules is relatively manually intensive, inefficient, time consuming and costly. This is at least partially due to the use of wire or long pin temperature sensors for cell temperature measurements. FIGS. 6-7 provide illustrations that are useful for understanding the conventional temperature sensor architecture of an energy module. This conventional architecture comprises a temperature sensor **606** that is mounted so as to extend into an empty space **604** between electrical energy storage cells **602₁**, **602₂**, **602₃**, **602₄** and so as to be located proximate to electrical energy storage cells **602₂**, **602₄.** In this way, the temperature of electrical energy storage cells **602₂**, **602₄** are coupled with the temperature sensor **606.** For example, the temperature sensor **606** can include a through-hole-technology (THT) sensor. The pins **700** of the temperature sensor **606** are soldered to a circuit board **702.** The placement of the temperature sensor **606** amongst the electrical energy storage cells and the soldering of the temperature sensor **606** to the circuit board **702** are manually performed during a manufacturing process of the energy module **600.**

The present solution provides a novel temperature sensor architecture for an energy module that eliminates the need for a long pinned temperature sensor in an energy module and therefore also eliminates the manual process. This is achieved through the use of a surface mount (SMT) sensor for measuring cell temperature. The SMT sensor is more suitable for an automated manufacturing process for the energy module with a minimized cost and time.

It should be noted that the SMT temperature sensor mounted on a circuit board may be more influenced by temperature sources on the same circuit board rather than by the electrical energy storage cells. Moreover, a farther proximity of an SMT sensor from the electrical energy storage cells may cause reduction in temperature measurement capability or reliability. Thus, the present solution addresses this issue by maximizing the thermal conductivity from the SMT temperature sensor to the battery cell and minimizes the thermal conductivity from SMT temperature sensor to other temperature sources on the circuit board. The manner in which this is accomplished will become evident as the discussion progresses. However, in general, this is achieved with SMT temperature placement, circuit board layout, use of cell voltage sense connections, and/or other optional aspects to improve or reduce thermal conductivity in one or other direction.

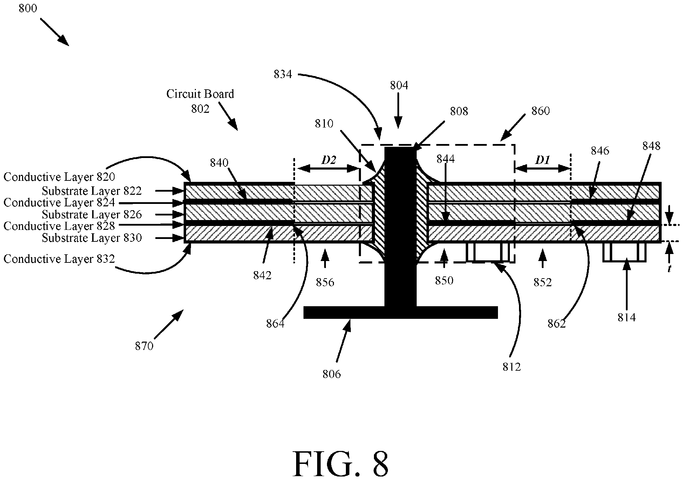

FIG. 8 provides a perspective view of an illustrative architecture for an internal circuit **800** of an energy module. The energy module can include, but is not limited to, energy module **104** of FIG. 1, energy module **104₁,** ..., **104_{N}** of FIG. 2, or the energy module of FIG. 3. The circuit **120** of FIGS. 4-5 can be the same as or similar to circuit **800** of FIG. 8.

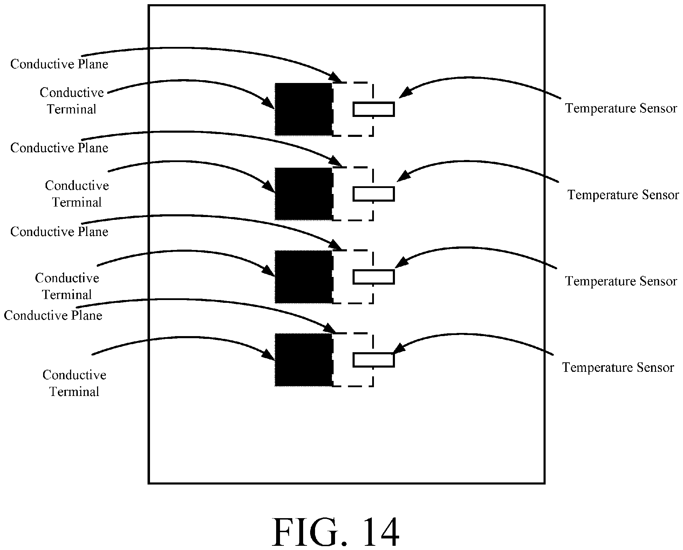

As seen in FIG. 8, internal circuit **800** will be described in relation to a single conductive terminal **804** and a single temperature sensor **812** for simplicity of discussion. Conductive terminal **804** may be configured to facilitate voltage sensing and measurements. In other words, the main purpose of the conductive terminal **804** may be to provide electrical signals at the internal circuit **800.** However, it should be understood that internal circuit **800** can include any number of conductive terminals and temperature sensors selected in accordance with a particular application. For example, as shown in a top view of FIG. 14, the circuit can include four conductive terminals and four temperature sensors. The present solution is not limited to the particulars of FIG. 14. The following discussion is sufficient for understanding the architecture for each pair of sensors **804, 812** provided with an internal circuit of an energy module.

It should also be noted that a data processor (e.g., data processor **502**) is electrically connected to the conductive terminal **804** and the temperature sensor **812** so that voltage and temperature measurements can be received thereby. The data processor is configured to detect when voltage and temperature measurements fall outside of pre-specified ranges. The data processor and these electrical connections are not shown in FIG. 8 for ease and simplicity of illustration.

The conductive terminal **804** comprises a distal end **806** that can be welded or otherwise coupled to the electrical energy storage cells. The conductive terminal **804** can include, but is not limited to, conductive terminal **404** of FIG. 4. The temperature sensor **812** can include, but is not limited to, a surface mount thermistor or other surface mount temperature sensor.

In addition to the components **804** and **812,** circuit **800** comprises other electronic component(s) **814** mounted on a multi-layer circuit board **802.** The electronic component(s) can include, but are not limited to, resistor(s), capacitor(s), inductor(s), amplifier(s), filter(s), selective circuit interrupt(s) (e.g., selective circuit interrupt **570** of FIG. 5), voltage regulator(s) (e.g., voltage regulator **542** of FIG. 5), isolator(s) (e.g., isolators **540** of FIG. 5), processor(s) (e.g., data processor **502** of FIG. 5), gate driver(s) (e.g., gate driver **504** of FIG. 5), a transistor active bridge circuit (e.g., transistor active bridge circuit **550** of FIG. 5).

Multi-layer circuit board **802** comprises substrate layers **822, 826, 830** and conductive layers **820, 824, 828, 832.** The exact number of layers which the circuit board **802** have is not essential or limiting to the present teachings. Substrate layers **822, 826, 830** are formed of the same or different dielectric material. Each of the conductive layers **820, 824, 828, 832** may comprise one or more conductors **840, 842, 844, 846, 848** formed thereon. Conductors **840, 842, 844, 846, 848** can include, but are not limited to, traces. It should be noted that the present solution is not limited to the conductive layer architecture shown in FIGS. 8-10. For example, conductive layer **820** may be less than or greater than distance **D2** from a conductive connection **810.** Additionally or alternatively, conductive layer **820** may cover all or a portion of a surface of substrate layer **822,** and/or comprise a conductive trace connecting the conductive connection **810** to another component residing elsewhere on the substrate layer **822.**

A through-hole pad **834** is formed through the circuit board **802.** A connection member **808** of the conductive terminal **804** extends through the through-hole pad **834.** Solder may be used to couple the connection member **808** to the circuit board **802** and provide an electrical connection between the conductive terminal **804** and conductor **844.** This connection is referred to as a conductive connection **810.** Conductive connection **810** can include, but is not limited to, a solder joint.

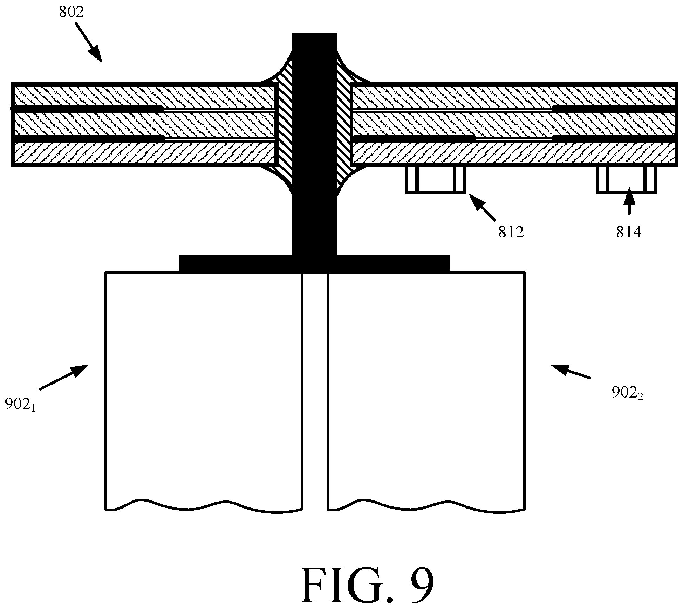

The temperature sensor **812** is mounted on a side **870** of the circuit **800** which faces the electrical energy storage cells **902₁**, **902₂** when the module is assembled as illustrated in FIG. 9. The temperature sensor **812** is located proximate to the conductive terminal **804** and conductor **844** so that it can detect the temperature of the electrical energy storage cells **902₁**, **902₂** via the conductive terminal **804.** Since the distal end **806** of the conductive terminal **804** is conductively connected directly to the electrical energy storage cells **902₁**, **902₂**, the conductive terminal **804** also provides relatively good thermal conductivity suitable for cell temperature measurements, while providing the main purpose of relatively good electrical conductivity suitable for cell voltage measurements. Hence, an electrical component having the main purpose of establishing electrical connection is further leveraged to obtain more accurate temperature measurements in a non-contact fashion with a device-under-monitoring. It shall be appreciated that the "device-under-monitoring" in this case would be one or more of the electrical energy storage cells.

It should be noted that the temperature sensor **812** is electrically not directly connected to the conductive terminal **804.** An electrical isolation between the temperature sensor **812** and the conductive terminal **804** is facilitated by the design of the multi-layer circuit board **802,** the relatively positions of the two components **804, 812,** and the relative positions of components **812, 844.** First, the thickness ***t*** of the substrate layer **830** is selected to be relatively thin. For example, this thickness ***t*** is selected to be less than 0.2 mm in some scenarios to ensure that conductive layers **828, 832** are located relatively close to each other. Second, a conductive trace or plane **844** is disposed on conductive layer **828** (i) so as to be electrically connected to the conductive terminal **804** via conductive connection **810** and (ii) so that it resides directly in proximity to (e.g., above) the temperature sensor **812.** The size, shape and/or material of the conductive plane **844** can be selected to maximize thermal conductivity to the temperature sensor **812.** For example, the conductive plane **844** may substantially overlap or extend the region occupied by the temperature sensor **812** on the layer **832.** The conductive plane **844** is formed of a conductive material configured to provide thermal conductivity with the conductive terminal **804.** The conductive material can include, but is not limited to, copper, tin, gold or other materials or alloys. The data processor may be electrically connected to the conductive terminal via the conductive plane. Thus, the conductive plane **844** may be leveraged also as a thermal conductor for the temperature sensor **812** besides performing its main task of routing or establishing electrical connection of the conductive terminal **804** with other electrical components. This can save space and costs. This can also simplify production process, e.g., assembly of the energy module **104.** By preventing leaded temperature sensor, deformed sensor leads can be avoided in production. This can enhance production yield of assembled modules.

The substrate layer **830** is formed of a material configured to provide thermal conductivity and electrical isolation between conductive connection **810** and temperature sensor **812** and between conductive plane **844** and temperature sensor **812.** The temperature sensor **812** is disposed on the circuit board **802** at a location that provides a gap **850** between itself and the connection member **808** of the conductive terminal **804.** The size of gap **850** is selected to ensure that the temperature sensor is electrically isolated from the conductive connection **810.** Thus, the structure can allow a good thermal contact to the temperature sensor **812** despite being electrically isolated from the conductive terminal **804.**

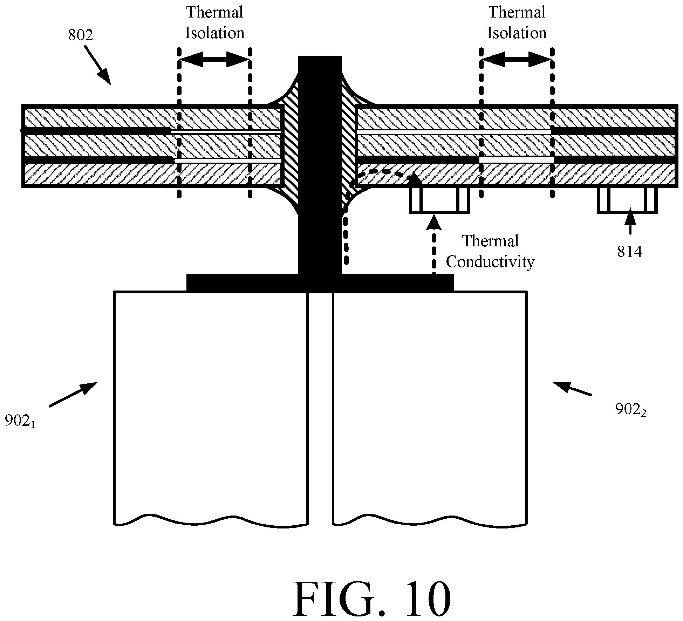

In FIG. 8, area **860** includes the conductive connection **810** and the temperature sensor **812.** Area **860** is thermally isolated from other electrical components of circuit **800.** The other electrical components include conductors **840, 842, 846, 848** and electronic component(s) **814.** A gap **852** is provided between area **860** and components **814, 846, 848.** The size and shape of gap **852** is selected so that area **860** is located at least a given distance ***D1*** from a closest edge **862** of each conductor **846, 848.** A gap **856** is also provided between area **860** and conductors **840, 842.** The size and shape of gap **856** is selected so that area **860** is located at least a given distance ***D2*** from a closest edge **864** of each conductor **840, 842.** Distances ***D1*** and ***D2*** are selected to ensure that there is a minimized amount of thermal conductivity between area **860** and components **814, 840, 842, 846, 848** of circuit **800.** An illustration is provided in FIG. 10 which shows the areas of thermal isolation and conductivity of circuit **800.**

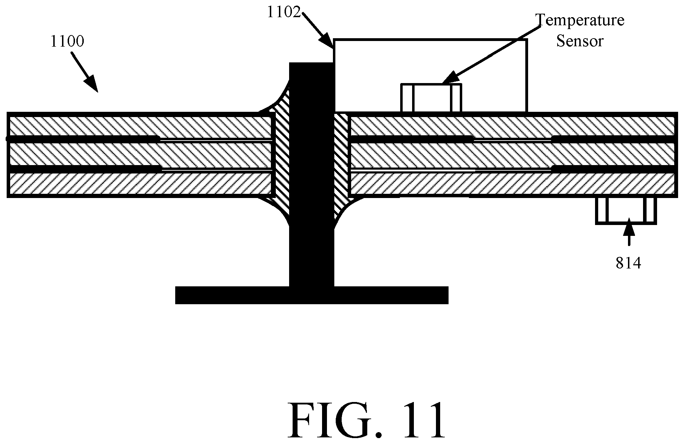

The present solution is not limited in the architecture shown in FIGS. 8-10. The temperature sensor could alternatively reside on the opposite side **1100** of the circuit board which faces away from the electrical energy storage cells as shown in FIG. 11. This alternative placement of the temperature sensor enables accessibility thereto after soldering a conductive terminal to the circuit board. After soldering the conductive terminal to the circuit board, the temperature sensor and the conductive connection could be thermally connected and still electrically isolated by any suitable material **1102.** This material **1100** can include, but is not limited to, a potting material, thermal glue and/or thermal paste.

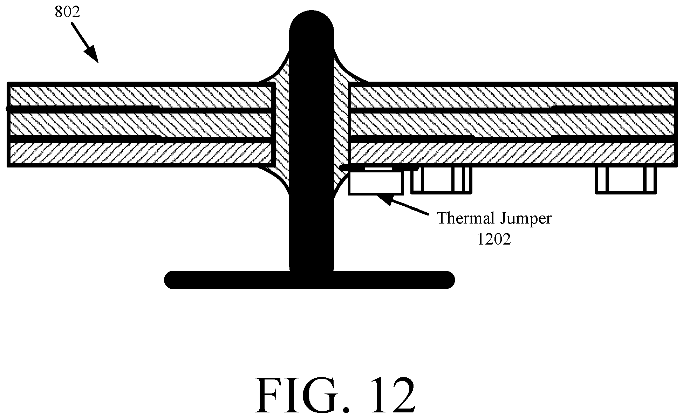

Alternatively or additionally, the thermal conductivity from the conductive connection **810** to the temperature sensor may be improved using one or more electrically isolating and thermally conductive member **1202** as shown in FIG. 12. The electrically isolating and thermally conductive member **1202** can include, but is not limited to, a thermal jumper, thermal paste, thermal glue and/or a thermal potting material. Member **1202** may be connected between the conductive connection **810** and/or the temperature sensor. Any known or to be known electrically isolating and thermally conductive member can be used here.

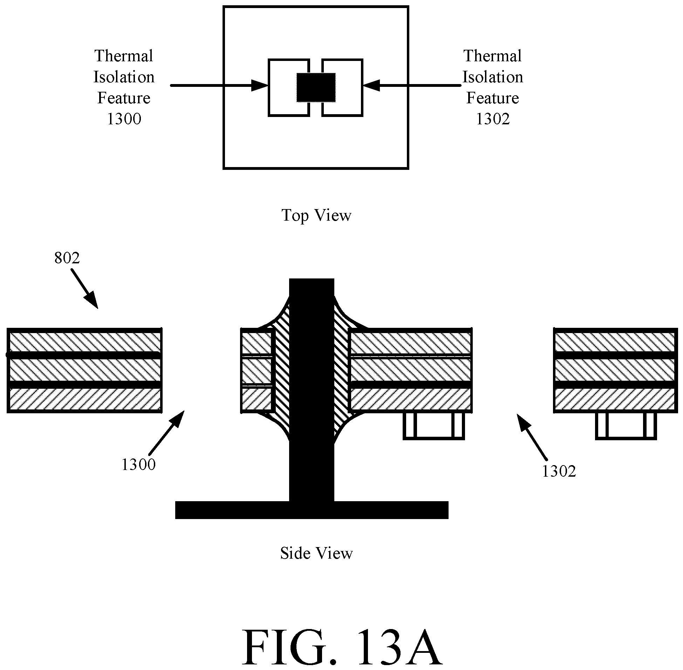

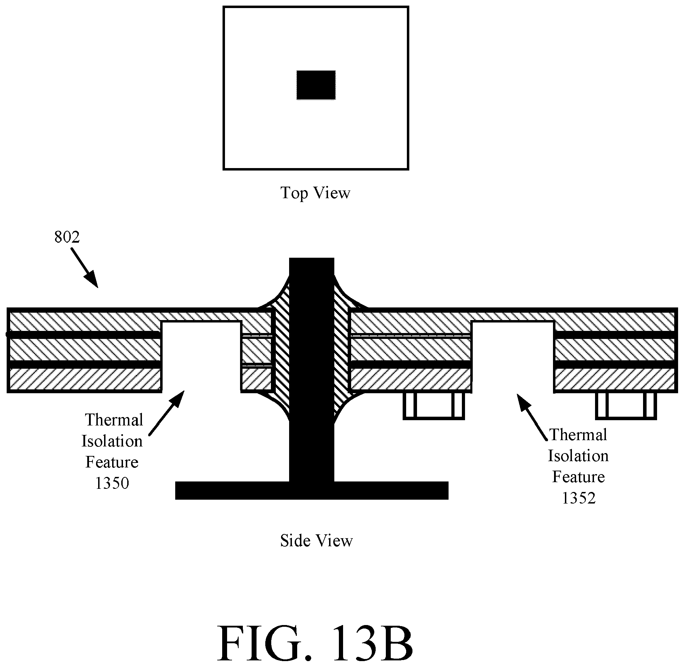

Alternatively or additionally, the circuit board can be milled or otherwise processed so that thermal isolation features are formed as voids therein to provide thermal isolation between area **860** and conductors **840, 842, 846, 848.** The thermal isolation features can extend all the way through the circuit board as shown in FIG. 13A or extend only partially through the circuit board as shown in FIG. 13B.

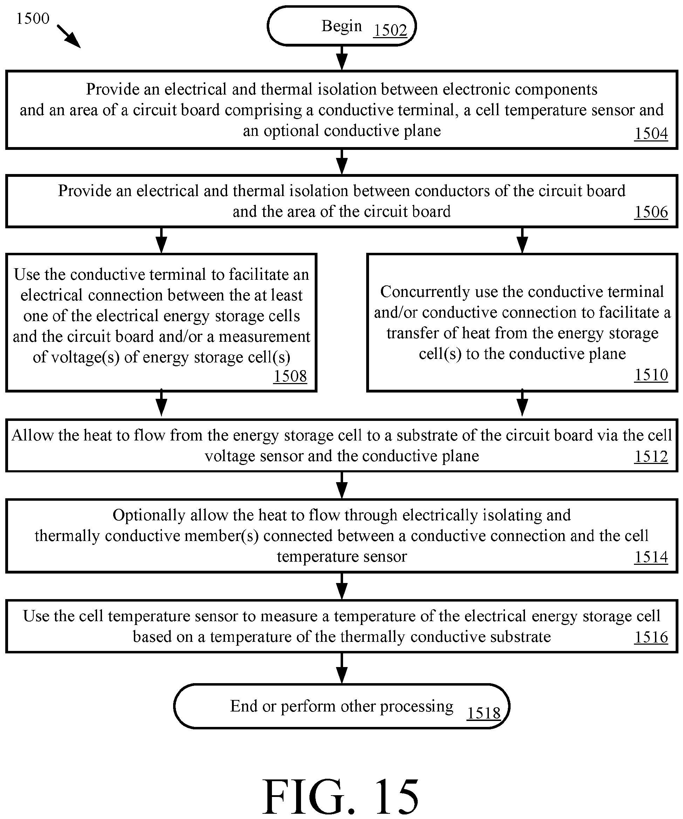

FIG. 15 provides a flow diagram of an illustrative method **1500** for operating a circuit. Method **1500** begins with **1502** and continues with **1504** where an electrical and thermal isolation is provided between electronic component(s) of the circuit (e.g., component(s) **814** of FIG. 8) and an area (e.g., area **860** of FIG. 8) of a circuit board (e.g., circuit board **802** of FIG. 8) comprising a conductive terminal (e.g., conductive terminal **804** of FIG. 8), a temperature sensor (e.g., temperature sensor **812** of FIG. 8) and an optional conductive plane (e.g., conductive plane **844** of FIG. 8). The thermal isolation may be provided by one or more gaps (e.g., gaps **852, 856** of FIG. 8, thermal isolation features **1300, 1302** of FIG. 13A, and/or thermal isolation features **1350, 1352** of FIG. 13) located on and within the circuit board between the other electronic components and the area. The gap(s) may be filled with a gas (e.g., air) or a portion of at least one material forming the circuit board or any other material providing thermal isolation. An electrical and thermal isolation is also provided in **1506** between conductors (e.g., conductors **840, 842, 846, 848** of FIG. 8) of the circuit board and the area of the circuit board comprising the cell voltage sensor, the temperature sensor and the optional conductive plane.

In **1508,** the conductive terminal is used to facilitate (i) an electrical connection between the at least one of the electrical energy storage cells and the circuit board and/or (ii) a measurement of voltage(s) of electrical energy storage cell(s) (e.g., electrical energy storage cell **902₁** and/or **902₂** of FIG. 9). As such, the conductive terminal is electrically connected to a data processor (e.g., data processor **502** of FIG. 5) so that the voltage measurement can be analyzed to detect when the electrical energy storage cell(s) are not operating as expected (e.g., the cell voltage falls outside an acceptable range of voltage values). This electrical connection between the conductive terminal and the data processor may be made using a conductor or a conductive plane disposed on a substrate layer of the circuit board.

The conductive terminal is also used in **1510** to facilitate a transfer of heat from the electrical energy storage cell(s) to the conductive plane provided within the circuit board. **1510** may also optionally involve using a conductive connection, provided between the conductive terminal and the circuit board, to further facilitate the transfer of heat from the electrical energy storage cell to the conductive plane.

In **1512,** heat is allowed to flow from the electrical energy storage cell to a substrate (e.g., substrate layer **830** of FIG. 8) of the circuit board via the conductive terminal, conductive connection and/or the conductive plane. The heat may also optionally be allowed to flow in 1514 through an electrically isolating and thermally conductive member (e.g., member **1202** of FIG. 12) that is connected between the conductive terminal and the temperature sensor.

In **1516,** the temperature sensor (e.g., temperature sensor **812** of FIG. 8) is used to measure a temperature of the electrical energy storage cell(s) based on a temperature of the substrate of the circuit board. The temperature sensor is mounted to a surface of the circuit board so as to be electrically isolated from the conductive terminal and the conductive plane. The conductive plane is disposed on a first side of the substrate layer and the temperature sensor is disposed on an opposite second side of the substrate layer at a location overlapped by the conductive plane.

Subsequently, method **1500** continues to block **1518** where it ends or other operations are performed. The other operations can include, but are not limited to, returning to block **1502.**

Although the present solution has been illustrated and described with respect to one or more implementations, equivalent alterations and modifications will occur to others skilled in the art upon the reading and understanding of this specification and the annexed drawings. In addition, while a particular feature of the present solution may have been disclosed with respect to only one of several implementations, such feature may be combined with one or more other features of the other implementations as may be desired and advantageous for any given or particular application. Thus, the breadth and scope of the present solution should not be limited by any of the above described scenarios. Rather, the scope of the present solution should be defined in accordance with the following claims and their equivalents.

Without excluding further possible embodiments, certain example embodiments are summarized in the following clauses:
Clause 1: A circuit comprising: one or more electrical energy storage cells; a circuit board comprising an electrically isolating substrate; an electrically conductive terminal connected between at least one of the electrical energy storage cells and the circuit board, the electrically conductive terminal being configured to concurrently facilitate (i) an electrical connection between the at least one of the electrical energy storage cells and the circuit board and (ii) a transfer of heat from the at least one of the electrical energy storage cells to the electrically isolating substrate; and a temperature sensor mounted to a surface of the circuit board and configured to measure a temperature of the at least one of the electrical energy storage cells based on a temperature of the electrically isolating substrate of the circuit board. The temperature sensor is electrically isolated from the electrically conductive terminal. Heat is allowed to flow from the at least one of the electrical energy storage cells to the temperature sensor via the electrically conductive terminal and the electrically isolating substrate.
Clause 2: The circuit of clause 1, further comprising a conductive connection provided between the electrically conductive terminal and the circuit board that is configured to further facilitate the transfer of heat from the at least one of the electrical energy storage cells to a conductive plane disposed on the electrically isolating substrate.
Clause 3: The circuit of any of the preceding clauses, wherein the conductive connection provides a path by which heat is allowed to further flow to the temperature sensor.
Clause 4: The circuit of any of the preceding clauses, further comprising an electrically isolating and thermally conductive member connected between the conductive connection and the temperature sensor.
Clause 5: The circuit according to any of the preceding clauses, wherein a conductive plane is disposed on a first side of the substrate and the temperature sensor is disposed on an opposite second side of the substrate at a location overlapped by the conductive plane.
Clause 6: The circuit according to any of the preceding clauses, further comprising at least one other electronic component that is thermally isolated from an area of the circuit board comprising the conductive terminal, the temperature sensor and a conductive plane disposed on the substrate.
Clause 7: The circuit according to any of the preceding clauses, further comprising one or more gaps located on and within the circuit board between the area and the at least one other electronic component.
Clause 8: The circuit according to any of the preceding clauses, wherein the one or more gaps are filled with a gas or other thermally isolating material comprises a portion of at least one material forming the circuit board.
Clause 9: The circuit according to any of the preceding clauses, wherein a plurality of conductors of the circuit board are thermally isolated from an area of the circuit board comprising the conductive terminal, the temperature sensor and a conductive plane disposed on a substrate.
Clause 10: The circuit according to any of the preceding clauses, further comprising a data processor electrically connected to the conductive terminal and the temperature sensor, and configured to detect when voltage and temperature measurements fall outside of pre-specified ranges.
Clause 11: A method for operating a circuit, comprising: using a conductive terminal to concurrently facilitate (i) a measurement of a voltage of an electrical energy storage cell and (ii) a transfer of heat from the electrical energy storage cell to a conductive plane provided within a circuit board; allowing the heat to flow from the electrical energy storage cell to a substrate of the circuit board via the conductive terminal and the conductive plane; and using a temperature sensor, which is mounted to a surface of the circuit board, to measure a temperature of the electrical energy storage cell based on a temperature of the substrate of the circuit board, wherein the temperature sensor is electrically isolated from the conductive terminal and the conductive plane.
Clause 12: The method according to clause 11, further comprising using a conductive connection, provided between the conductive terminal and the circuit board, to further facilitate the transfer of heat from the electrical energy storage cell to the conductive plane.
Clause 13: The method according to any of the preceding method clauses, further comprising allowing the heat to further flow through the conductive connection.
Clause 14: The method according to any of the preceding method clauses, further comprising allowing the heat to further flow through an electrically isolating and thermally conductive member connected between the conductive connection and the temperature sensor.
Clause 15: The method according to any of the preceding method clauses, wherein the conductive plane is disposed on a first side of the substrate and the temperature sensor is disposed on an opposite second side of the substrate at a location overlapped by the conductive plane.
Clause 16: The method according to any of the preceding method clauses, further comprising providing a thermal isolation between other electronic components or conductors and an area of the circuit board comprising the conductive terminal, the temperature sensor and the conductive plane.
Clause 17: The method according to any of the preceding method clauses, wherein the thermal isolation is provided by one or more gaps located on and within the circuit board between the other electronic components or conductors and the area.
Clause 18: The method according to any of the preceding method clauses, wherein the one or more gaps are filled with a gas or comprises a portion of at least one material forming the circuit board.
Clause 19: The method according to any of the preceding method clauses, further comprising providing an electrical connection between the conductive terminal, the temperature sensor and a data processor of the circuit.
Clause 20: An arrangement (e.g., a circuit or system) comprising means for performing the steps of any of the above method clauses.

The breadth and scope of this disclosure should not be limited by any of the above-described example embodiments, but should be defined only in accordance with the following claims and their equivalents.

## Claims

1. A circuit, comprising:
one or more electrical energy storage cells;
a circuit board comprising an electrically isolating substrate;
an electrically conductive terminal connected between at least one of the electrical energy storage cells and the circuit board, the electrically conductive terminal being configured to concurrently facilitate (i) an electrical connection between the at least one of the electrical energy storage cells and the circuit board and (ii) a transfer of heat from the at least one of the electrical energy storage cells to the electrically isolating substrate; and
a temperature sensor mounted to a surface of the circuit board and configured to measure a temperature of the at least one of the electrical energy storage cells based on a temperature of the electrically isolating substrate of the circuit board, wherein the temperature sensor is electrically isolated from the electrically conductive terminal;
wherein heat is allowed to flow from the at least one of the electrical energy storage cells to the temperature sensor via the electrically conductive terminal and the electrically isolating substrate.

2. The circuit according to claim 1, further comprising a conductive connection provided between the electrically conductive terminal and the circuit board that is configured to further facilitate the transfer of heat from the at least one of the electrical energy storage cells to a conductive plane disposed on the electrically isolating substrate.

3. The circuit according to claim 2, wherein the conductive connection provides a path by which heat is allowed to further flow to the temperature sensor.

4. The circuit according to claim 2 or claim 3, further comprising an electrically isolating and thermally conductive member connected between the conductive connection and the temperature sensor.

5. The circuit according to any of the preceding claims, wherein a conductive plane is disposed on a first side of the substrate and the temperature sensor is disposed on an opposite second side of the substrate at a location overlapped by the conductive plane.

6. The circuit according to any of the preceding claims, further comprising at least one other electronic component that is thermally isolated from an area of the circuit board comprising the conductive terminal, the temperature sensor and a conductive plane disposed on the substrate.

7. The circuit according to any of the preceding claims, further comprising one or more gaps located on and within the circuit board between the area and the at least one other electronic component.

8. The circuit according to claim 7, wherein the one or more gaps are filled with a gas or comprises a portion of at least one material forming the circuit board.

9. The circuit according to any of the preceding claims, wherein a plurality of conductors of the circuit board are thermally isolated from an area of the circuit board comprising the conductive terminal, the temperature sensor and a conductive plane disposed on a substrate.

10. The circuit according to any of the preceding claims, further comprising a data processor electrically connected to the conductive terminal and the temperature sensor, and configured to detect when voltage and temperature measurements fall outside of pre-specified ranges.

11. A method for operating a circuit, comprising:
using a conductive terminal to concurrently facilitate (i) a measurement of a voltage of an electrical energy storage cell and (ii) a transfer of heat from the electrical energy storage cell to a conductive plane provided within a circuit board;
allowing the heat to flow from the electrical energy storage cell to a substrate of the circuit board via the conductive terminal and the conductive plane; and
using a temperature sensor, which is mounted to a surface of the circuit board, to measure a temperature of the electrical energy storage cell based on a temperature of the substrate of the circuit board, wherein the temperature sensor is electrically isolated from the conductive terminal and the conductive plane.

12. The method according to claim 11, further comprising using a conductive connection, provided between the conductive terminal and the circuit board, to further facilitate the transfer of heat from the electrical energy storage cell to the conductive plane.

13. The method according to claim 11 or 12, wherein the conductive plane is disposed on a first side of the substrate and the temperature sensor is disposed on an opposite second side of the substrate at a location overlapped by the conductive plane.

14. The method according to any of the preceding method claims, further comprising providing an electrical connection between the conductive terminal, the temperature sensor and a data processor of the circuit.

15. An arrangement comprising means for performing the steps of any of the preceding method claims.
